(19) Europäisches Patentamt
European Patent Office
Office européen des brevets

(11) **EP 2 673 586 B1**

(12) **FASCICULE DE BREVET EUROPEEN**

(45) Date de publication et mention de la délivrance du brevet:
**08.04.2015 Bulletin 2015/15**

(21) Numéro de dépôt: **12702567.4**

(22) Date de dépôt: **09.02.2012**

(51) Int Cl.:
*F28D 20/02* (2006.01)   *H01L 23/427* (2006.01)

(86) Numéro de dépôt international:
**PCT/EP2012/052219**

(87) Numéro de publication internationale:
**WO 2012/107523 (16.08.2012 Gazette 2012/33)**

(54) **DISPOSITIF ABSORBEUR THERMIQUE A MATERIAU A CHANGEMENT DE PHASE**

WÄRMEABSORBIERENDE VORRICHTUNG MIT PHASENUMWANDLUNGSMATERIAL

HEAT-ABSORBING DEVICE WITH PHASE-CHANGE MATERIAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.02.2011 FR 1151147**

(43) Date de publication de la demande:
**18.12.2013 Bulletin 2013/51**

(73) Titulaire: **Commissariat à l'Énergie Atomique et aux Énergies Alternatives 75015 Paris (FR)**

(72) Inventeur: **GAVILLET, Jérôme F-38120 Saint-egreve (FR)**

(74) Mandataire: **Ahner, Philippe BREVALEX 95, rue d'Amsterdam 75378 Paris Cedex 8 (FR)**

(56) Documents cités:
**EP-A2- 0 165 596        WO-A1-96/28846
US-A1- 2007 009 687**

**Description**

## DOMAINE TECHNIQUE ET ART ANTÉRIEUR

La présente invention se rapporte à un dispositif absorbeur thermique à matériau à changement de phase selon le preambule de la revendication 1. Un tel dispositif est connu de US 2007/009687A1, particulièrement adapté à l'absorption de la chaleur émise par des systèmes dans le domaine de l'électronique, de la microélectronique, de l'électronique de puissance. L'invention se rapporte aussi à un procédé de réalisation d'un tel dispositif.

Les composants électroniques sont sources d'émissions multiples de flux de chaleur, ceux-ci pouvant être alternativement transitoires et/ou stationnaires selon leur état de fonctionnement. Dans certains cas d'opération non contrôlée, la résultante de ces flux de chaleur peut conduire à un écart de température positif instantané et momentané par rapport à leur température nominale de fonctionnement. Dans certains cas, cet écart de température peut conduire à un endommagement ou à une perte de rendement du composant.

Par conséquent, afin d'assurer le bon fonctionnement des composants électroniques, une évacuation planifiée de la chaleur est requise.

Les flux de chaleur présentent des pics d'amplitudes et de périodes variables et de fréquences d'apparition différentes au cours du fonctionnement du système électronique, en fonction de son utilisation.

Il existe des dispositifs type radiateur permettant d'évacuer en continu la chaleur émise par les composants, cependant ils ne sont pas toujours capables de réagir lorsqu'un flux de chaleur aléatoire est émis. Il existe également des circuits de circulation d'un caloporteur en contact avec une face du composant pour extraire par échange thermique la chaleur. Ces circuits sont encombrants et requièrent des moyens pour faire circuler le fluide. En outre, comme précédemment, ils ne sont pas toujours capables d'absorber une quantité de chaleur émise aléatoirement. Ou alors, il est nécessaire de surdimensionner le circuit pour pouvoir absorber ces pics d'émission de flux de chaleur.

En outre, ces systèmes ne sont pas capables de répondre à une vitesse (ou fréquence) supérieure à la vitesse d'apparition de l'écart de température.

Il existe également un système mettant en oeuvre des matériaux à changement de phase, comme la paraffine, pour absorber la chaleur émise par un panneau photovoltaïque. Le système est disposé sur la face du panneau opposée à celle recevant le rayonnement solaire, et peut comporter des ailettes perpendiculaires à cette face et un matériau à changement de phase disposé dans les espaces inter-ailettes. La chaleur émise par le panneau est transmise au matériau à changement de phase ; lorsque la température du panneau est supérieure à la température de changement de phase du matériau, celui-ci entre en fusion en absorbant la chaleur émise par le panneau photovoltaïque.

Cependant, la quantité de chaleur absorbée est limitée par la quantité de matériau à changement de phase se trouvant en contact avec le panneau.

De plu, les matériaux à changement de phase présentant une mauvaise conductivité thermique, il n'est pas envisageable de réaliser des systèmes ayant une grande épaisseur de matériau à changement de phase.

En outre, une grande épaisseur de matériau n'offre pas une vitesse de réponse adaptée à des vitesses d'apparition d'écart de température. De plus, afin de permettre à nouveau au système d'absorber cette chaleur, la chaleur emmagasinée par le matériau à changement de phase doit être extraite. Or, dans le cas d'une grande épaisseur de matériau cette extraction n'est pas aisée.

## EXPOSÉ DE L'INVENTION

C'est par conséquent un but de la présente invention d'offrir un dispositif optimisé d'absorption de chaleur étant capable d'absorber des flux de chaleur émis par une source de chaleur imposant des conditions transitoires multiples d'opération, les conditions transitoires pouvant être simultanées ou décalées dans le temps.

Le but précédemment énoncé est atteint par un dispositif comportant une pluralité de cellules empilées contenant un matériau à changement de phase, la structure comportant plusieurs tailles de cellule, ces tailles de cellule étant déterminées pour absorber au mieux les pics suivant leur fréquence d'apparition, le nombre de cellules étant déterminé en fonction de l'amplitude relative des pics.

Selon l'invention, on met en oeuvre une pluralité de cellules, dont la taille est un paramètre d'ajustement de la cinétique du changement de phase. En effet, le matériau à changement de phase contenu dans une cellule plus grande fond complètement sur un temps plus long que celui contenu dans une cellule plus petite. Par conséquent pour des pics ayant une courte période de vie (fréquence de régime transitoire associée élevée), des cellules de petite taille absorbent efficacement la chaleur.

En d'autres termes, le système est réalisé en fonction des caractéristiques fréquentielles du flux thermique à absorber. Il comporte une pluralité de cellules composées d'un conducteur thermique et d'un matériau à changement de phase, chacune des zones étant particulièrement adaptée à absorber des pics thermiques de fréquence donnée. Chaque taille est choisie de sorte à répondre au mieux aux différentes fréquences d'apparition des flux de chaleur.

De manière particulièrement avantageuse, la structure comporte également des chemins de conduction thermique privilégiés s'étendant dans la direction du flux de chaleur de sorte à distribuer de manière uniforme la chaleur au sein de la structure et permettre une absorption de celle-ci par toutes les cellules. Ainsi il est possible de faire participer une grande quantité de matériau à changement de phase sur une certaine épaisseur pour extraire la chaleur, malgré sa faible conductivité thermique.

Les cellules forment une structure tridimensionnelle.

De préférence, les cellules sont interconnectées, et leur taux de remplissage est inférieur à l'unité ce qui permet au matériau à changement de phase de se dilater lors de sa fusion.

De manière très avantageuse, des canaux de circulation d'un caloporteur sont formés entre les cellules afin d'extraire la chaleur absorbée par chacune des cellules.

La présente invention a alors pour objet un dispositif d'absorption thermique comportant une structure comprenant une pluralité de cellules individuelles, chaque cellule étant délimitée par une enveloppe en un matériau présentant une bonne conductivité thermique et contenant au moins un matériau à changement de phase, ladite structure comportant une première surface d'extrémité destinée à être en contact avec une surface émettant un flux thermique à absorber, ledit flux thermique étant composé d'au moins deux événements thermiques d'amplitudes différentes et de fréquences différentes, lesdites cellules étant empilées les unes sur les autres à partir de ladite surface d'extrémité de sorte que la structure s'étende au moins le long de la direction du flux thermique, les cellules étant en contact les unes avec les autres par leur enveloppe, ladite structure comprenant au moins une première taille de cellule et une deuxième taille de cellule, la quantité de matériau à changement de phase dans chaque cellule étant proportionnelle à sa taille, dans lequel la première taille de cellule est déterminée en fonction de la fréquence du premier événement et la deuxième taille de cellule est déterminée en fonction de la fréquence du deuxième événement et dans lequel la répartition entre le nombre de cellules de première taille et le nombre de cellules de deuxième taille est déterminée en fonction des amplitudes des premier et deuxième événements. La première taille de cellule et la deuxième taille de cellule augmentent lorsque que la fréquence du premier événement et la fréquence du deuxième événement respectivement diminuent et le nombre de cellules de première taille et le nombre de cellules de deuxième taille augmentent lorsque l'amplitude du premier événement et l'amplitude du deuxième événement respectivement augmentent.

De préférence, lorsque la fréquence du deuxième événement est inférieure à celle du premier événement, la deuxième taille de cellule est supérieure à la première taille de cellule, et les cellules de première taille sont situées du côté de la première surface d'extrémité.

Avantageusement, la taille des cellules croît le long de la direction du flux thermique à partir de la première surface d'extrémité.

De manière particulièrement intéressante, les cellules sont interconnectées de sorte à permettre le passage des matériaux à changement de phase d'une cellule à l'autre. Les cellules sont alors de préférence interconnectées dans la direction du flux thermique.

Dans un mode de réalisation particulièrement avantageux, le dispositif d'absorption thermique comporte également au moins un chemin de conduction thermique privilégié s'étendant à partir de la première surface d'extrémité dans la direction du flux thermique entre les cellules. Le dispositif d'absorption thermique peut comporter plusieurs chemins de conduction privilégiés répartis régulièrement dans la structure.

Par exemple, le au moins un chemin de conduction privilégié est formé par une portion de matériau conducteur thermique située entre les cellules et s'étendant le long de la direction du flux thermique. La portion de matériau conducteur thermique est de préférence du même matériau que celui de parois des cellules, par exemple en cuivre ou en acier Maraging. La portion de matériau conducteur thermique et les enveloppes des cellules en contact avec ladite portion peuvent être d'un seul tenant.

Le dispositif d'absorption thermique peut également comporter des moyens pour extraire la chaleur latente stockée dans le matériau à changement de phase. Il peut s'agit d'au moins un canal entre les cellules, dans lequel circule un caloporteur. Avantageusement, la circulation du caloporteur est commandée en fonction de la survenue d'un événement thermique.

Le dispositif d'absorption thermique comporte préférentiellement des moyens pour isoler thermiquement les bords latéraux de l'empilement.

Par exemple, le au moins un matériau à changement de phase mis en oeuvre ayant une température de changement de phase comprise entre 50°C et 350°C.

Dans un mode particulier de réalisation, le dispositif d'absorption thermique comporte trois tailles de cellules de formes parallélépipédiques, les cellules de chaque taille étant disposées dans une couche, les cellules étant interconnectées entre chaque couche.

La présente invention a également pour objet un procédé de réalisation d'un dispositif d'absorption thermique selon la présente invention destiné à absorber un flux thermique de période émis par une source de chaleur, comportant les étapes :

- calcul à partir de la fonction représentative dudit flux thermique périodique d'un développement limité d'ordre n de fonctions périodiques, par exemple sinusoïdales, correspondant chacune à une source de chaleur individuelle ayant une certaine fréquence,
- sélection des fonctions périodiques, par exemples sinusoïdales, dont la somme des amplitudes est supérieure à un pourcentage donné de l'amplitude maximale du flux thermique, le pourcentage donné étant par exemple compris entre de 60 à 98%,
- détermination de la taille des cellules en fonction des fréquences des fonctions sélectionnées, la taille des cellules augmentant lorsque que la fréquence des fonctions sélectionnées diminue,
- détermination de la répartition du nombre de cellules de chaque taille en fonction de l'amplitude des fonctions sélectionnées, le nombre de cellules de chaque taille augmentant lorsque l'amplitude des fonctions sélectionnées, augmente,
- réalisation d'un dispositif muni de cellules dont la taille et le nombre correspondent à ceux déterminés lors des deux étapes précédentes.

**BRÈVE DESCRIPTION DES DESSINS**

La présente invention sera mieux comprise à l'aide de la description qui va suivre et des dessins en annexes sur lesquels :

- la figure 1 est une vue en coupe schématique d'un exemple de réalisation d'une structure d'absorption thermique,
- la figure 2 est un autre exemple de réalisation d'une structure d'absorption thermique,
- la figure 3 est un autre exemple de réalisation d'une structure d'absorption thermique,
- la figure 4 est une vue en perspective d'un exemple de réalisation pratique de la structure de la figure 3,
- la figure 5 est une représentation graphique de la variation de la profondeur de pénétration thermique pour différents matériaux à changement de phase et pour différents matériaux d'enveloppe en fonction de la fréquence des flux thermiques,
- la figure 6A est une représentation graphique d'une fonction représentative d'un exemple d'un flux de chaleur,
- la figure 6B est une représentation graphique du développement limité en 11 fonctions sinusoïdales de la fonction de la figure 6A,
- la figure 6C est une représentation graphique des amplitudes des fonctions sinusoïdales de la figure 6B,
- la figure 7A est une représentation graphique d'une autre fonction représentative d'un exemple d'un flux de chaleur,
- la figure 7B est une représentation graphique du développement limité en 11 fonctions sinusoïdales de la fonction de la figure 7A,
- la figure 7C est une représentation graphique des amplitudes des fonctions sinusoïdales de la figure 7B,
- les figures 8A et 8B sont des représentations graphiques, à des échelles de temps différentes, des signaux représentatifs d'un flux thermique auquel la structure de la figure 4 est particulièrement adaptée.

**EXPOSÉ DÉTAILLÉ DE MODES DE RÉALISATION PARTICULIERS**

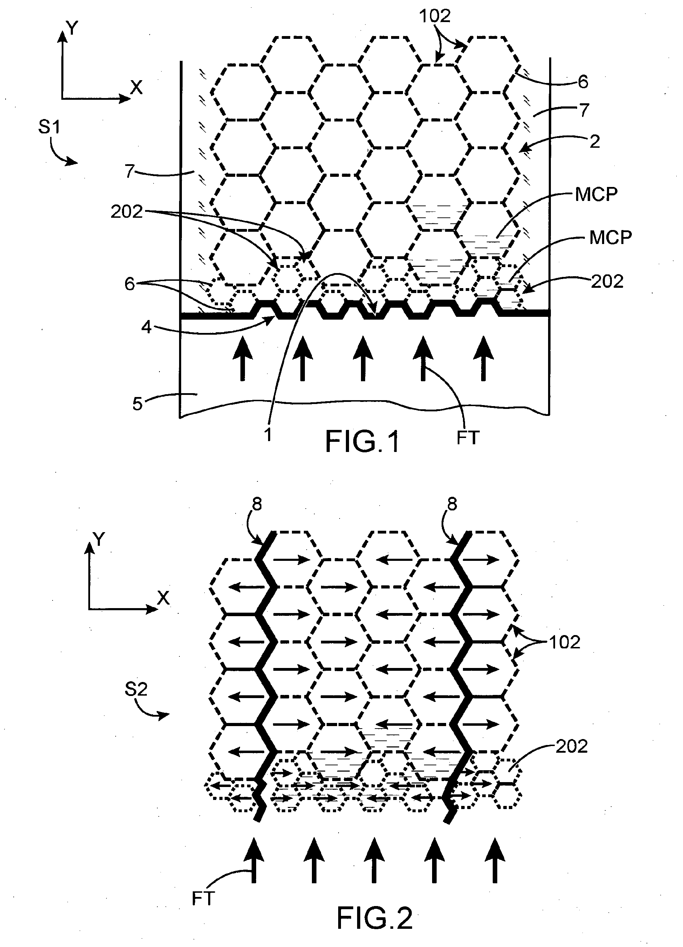

Sur la figure 1, on peut voir un exemple de réalisation d'une structure S1 d'absorption thermique selon la présente invention.

La structure S1 comporte une surface d'extrémité 1 destinée à être en contact avec une surface 4 d'un système 5 duquel on souhaite extraire la chaleur. Par exemple, ce système est un composant électronique.

Dans la présente invention, les matériaux à changement de phase seront désignés par la suite par MCP. On entend par matériau à changement de phase, un matériau à changement de phase thermique, i.e. capable de changer d'état physique à une température donnée. Par exemple, le MCP fond et passe de l'état solide à l'état liquide ou de l'état liquide à l'état gazeux lorsque, sa température augmentant, elle atteint la température de fusion ou d'évaporation du matériau, et se solidifie ou se liquéfie lorsque, sa température diminuant, elle atteint la température de solidification ou de condensation du matériau.

De préférence, les températures de changement de phase des MCP mis en oeuvre sont comprises entre 50°C et 350°C, ce qui permet une application de la structure d'absorption au domaine de la microélectronique, de l'électronique, et de l'électronique de puissance.

Les matériaux à changement de phase correspondant à cet intervalle peuvent être organiques, par exemple de la paraffine commerciale, des hydrates de sel, comme le Magnésium Nitrate hexahydrate, le Sodium hydroxyde monohydrate, $MgCl_2*6H_2O$, des sels tels que $LiNO_3$, $NaNO_3$, $KNO_3$, $NaNO_3$-$KNO_3$.

La structure S1 comporte une pluralité de cellules 2 en contact les unes avec les autres. Chaque cellule 2 comporte une enveloppe 6 et un MCP (représenté schématiquement) disposé dans l'enveloppe 6. L'enveloppe 6 est en un matériau conducteur thermique, de préférence en un matériau métallique tel que le cuivre et l'acier Maragine qui offrent de bonnes conductivités thermiques. Par bonne conductivité thermique, on entend dans la présente invention une conductivité thermique supérieure à 1 W/K/m, de préférence supérieure à 50 W/K/m, de préférence encore supérieure à 100 W/K/m.

Dans l'exemple représenté, chaque cellule 2 a la forme d'un hexaèdre de sorte que la structure soit du type nid d'abeille. Cette forme n'est en aucun cas limitative, on pourrait envisager par exemple des cellules cylindriques à section circulaire ou quelconque, des cellules parallélépipédiques ou de toute autre forme polyédrique.

Les enveloppes peuvent être fermées de manière étanche, dans ce cas on prévoit que le volume intérieur de la cellule soit suffisant pour accommoder les variations de volume du MCP lors de changement de phase.

Les enveloppes peuvent être avantageusement ouvertes, comme cela est représenté de manière schématique par les traits en pointillés des enveloppes sur la figure 1. Les cellules étant interconnectées, le MCP peut alors passer d'une cellule aux cellules voisines, ce qui assure l'accommodation de la variation de volume. Le fait d'avoir des Cellules ouvertes est également avantageux pour le remplissage de l'enveloppe avec le MCP. Une structure dans laquelle les cellules seraient interconnectées par groupe et non toutes ensemble ne sort pas du cadre de la présente invention.

De préférence, les cellules sont interconnectées dans la direction du flux thermique.

De préférence, la structure est réalisée d'un seul tenant, les parois latérales de deux cellules adjacentes étant communes. La structure comporte également des parois avant et arrière (non représentées) pour fermer les cellules dans la représentation de la figure 1 formées par exemple par des plaques rapportées. La structure S1 est alors telle qu'elle forme un ensemble étanche.

Dans la structure S1, les cellules 2 forment une structure bidimensionnelle s'étendant sensiblement le long d'un axe X le long de la surface 4 du système et le long d'un axe Y orthogonal à l'axe X.

Les cellules sont alors disposées sensiblement sous forme de lignes empilées les unes sur les autres. Dans une structure tridimensionnelle, les cellules sont reparties sensiblement en couches.

La surface 4 émet un flux thermique symbolisé par la flèche désignée FT le long de la direction de l'axe Y, c'est ce flux FT que la structure S1 est destinée à absorber.

De préférence, la structure S1 comporte des moyens 7 d'isolation thermique latéraux afin de guider le flux thermique le long de l'axe Y. Les moyens d'isolation thermique 5 sont, par exemple formés par un matériau calorifuge rapporté sur les faces latérales extérieures de la structure ou par des zones de vide.

Comme on peut le voir sur la figure 1, la structure S2 comporte des cellules de deux tailles différentes, des cellules 102 ayant une première taille et des cellules 202 ayant une deuxième taille. La première taille est supérieure à la deuxième taille.

On entend par " taille ", le volume de la cellule. Par ailleurs, la quantité de MCP contenu dans une cellule est proportionnelle à sa taille. Ainsi une cellule de grande taille contient plus de MCP qu'une cellule de petite taille. Ainsi dans la suite de la description, les expressions " taille de cellule " et " quantité de MCP " ou "volume de MCP" seront utilisées invariablement.

De préférence, le volume de MCP à l'état liquide (état dilaté, dans le cas d'un changement de phase solide-liquide), est le plus proche possible du volume de la cellule afin d'optimiser le remplissage du système et donc son efficacité. De préférence, le PCM à l'état solide remplit donc de 80% à 95% de la cellule, en tenant compte du taux de dilatation solide-liquide qui est typiquement compris entre 5% et 20%.

Dans l'exemple représenté et de manière préférée, les cellules de petite taille 202 sont situées du côté de la surface 4 émettrice de chaleur et les cellules de grande taille 102 sont situées au plus loin de cette surface empilées sur les cellules 202.

Cette configuration est avantageuse car, d'une part les cellules de petite taille sont adaptées à l'absorption des pics de fréquence élevée car le MCP contenu en petite quantité dans chaque cellule fond plus rapidement. En outre, la chaleur émise par les pics de fréquence élevée pénètre "moins profondément" dans la structure puisqu'ils sont de plus courte durée. Il est donc préférable que les petites cellules soient situées au plus près de la surface 4.

Nous allons maintenant expliquer le fonctionnement de la structure S1.

La surface 4 émet un flux thermique que la structure S1 doit absorber. La chaleur va circuler dans les enveloppes 6 des cellules 2 en contact direct avec la surface émettrice 4 et va se diffuser dans toute la structure par l'intermédiaire du matériau des enveloppes qui présente une bonne, voire une très bonne conductivité thermique, et également par le MCP. Du fait de l'élévation de la température, le MCP contenu dans les cellules change de phase, passant soit de l'état solide à l'état liquide, soit de l'état liquide à l'état gazeux. Ce changement de phase absorbe l'énergie thermique qui est stockée sous forme de chaleur latente dans chacune des cellules.

La chaleur absorbée est ensuite évacuée, i.e. la structure est refroidie pour rendre le dispositif à nouveau apte à absorber un nouveau flux thermique. Par ce refroidissement, le MCP change à nouveau de phase et passe de l'état liquide à l'état solide ou de l'état gazeux à l'état liquide. Par exemple, ce refroidissement est obtenu en faisant circuler un caloporteur, liquide ou gazeux, dans ou autour de la structure.

Par ailleurs, la chaleur, émise par les pics de fréquence élevée, i.e. qui est émise pendant une courte durée, est absorbée par les petites cellules, le MCP qu'elles contiennent, qui s'y trouve en faible volume, fond rapidement. Le stockage de la chaleur sous forme de chaleur latente a lieu rapidement. La chaleur est donc absorbée rapidement.

Lorsque les pics ont une fréquence faible, i.e. ils émettent de la chaleur pendant une durée importante, les cellules de grande taille contenant une certaine quantité de MCP fond moins rapidement et stockent cette chaleur sous forme de chaleur latente.

La structure peut comporter plus de deux tailles de cellules en fonction du flux et des différentes fréquences des événements émetteurs de chaleur.

Sur la figure 2, on peut voir un autre exemple de réalisation d'une structure S2 d'absorption thermique.

La structure S2 comporte, comme la structure S1, différentes tailles de cellules.

Elle comporte, en outre, de manière particulièrement avantageuse au moins un chemin 8 de conduction thermique privilégié afin d'améliorer encore la distribution de la chaleur à absorber au sein de la structure S2.

Les chemins de conduction thermique privilégiés 8 par lesquels le flux thermique FT circule préférentiellement, sont orientés sensiblement le long de la direction du flux FT. Les chemins 8 sont formés par des zones en un matériau conducteur thermique dont l'épaisseur est supérieure à celle des enveloppes de sorte à favoriser le passage du flux thermique par ces zones. De préférence, il s'agit du même matériau que celui formant les enveloppes de sorte à assurer une conductivité thermique uniforme. On pourrait choisir un autre matériau ayant une conductivité thermique proche de celle des enveloppes.

Les chemins 8 peuvent être formés soit directement par les enveloppes, celles-ci comportent alors une portion de plus grande épaisseur, soit par des éléments insérés entre les enveloppes, leur forme étant choisie pour assurer un contact intime avec les enveloppes.

Nous allons maintenant expliquer le fonctionnement de la structure S1. Il est rappelé que les MCP offrent une faible conductivité thermique, très inférieure à celle du matériau des enveloppes.

La surface 4 émet un flux thermique que la structure S2 doit absorber. L'énergie thermique circule dans les enveloppes des cellules 2 en contact direct avec la surface 4. De plus, la chaleur emprunte préférentiellement les chemins 8. Cette chaleur est ensuite distribuée latéralement dans les cellules comme cela est symbolisé par les flèches. L'énergie à absorber est alors apportée au plus près de cellules et de manière sensiblement homogène. Ainsi toutes les cellules participent de manière uniforme à l'absorption de l'énergie thermique.

Du fait de l'élévation de la température, le MCP contenu dans les cellules change de phase, passant soit de l'état solide à l'état liquide, soit de l'état liquide à l'état gazeux. Ce changement de phase absorbe l'énergie thermique qui est stockée sous forme de chaleur latente dans chacune des cellules.

La chaleur absorbée est ensuite évacuée, i.e. la structure est refroidie pour que le MCP change à nouveau de phase et passe de l'état liquide à l'état solide ou de l'état gazeux à l'état liquide. Par exemple, ce refroidissement est obtenu en faisant circuler un caloporteur, liquide ou gazeux, autour de la structure.

On peut ainsi utiliser un grand nombre de cellules empilées et donc augmenter la quantité de stockage de la chaleur, sans que la faible conductivité thermique du MCP soit pénalisante et ne provoque l'apparition d'un fort gradient thermique au sein de la structure S2.

Par exemple, la taille des cellules est comprise entre 1 $\mu$m et 1 cm. L'épaisseur de l'enveloppe représente de 1% à 20% de la taille de la cellule. L'épaisseur du chemin représente de 20% à 100% de la taille de la cellule. Dans le cas où l'épaisseur du chemin de conduction privilégié représente 100% de la taille de la cellule, l'emplacement d'une ligne de cellules est utilisé pour créer un chemin de conduction.

Des chemins thermiques 8 sont distribués dans la structure en fonction de la quantité de chaleur à absorber. De préférence, ils sont distribués de manière régulière de sorte à assurer une distribution la plus homogène possible de la chaleur au sein de la structure.

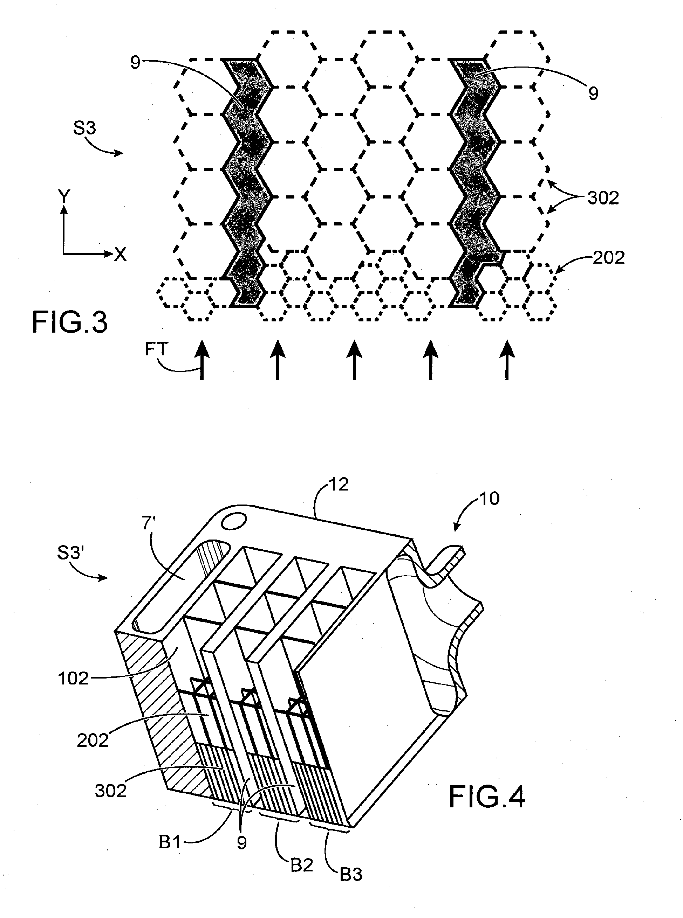

Sur la figure 3, on peut voir un autre exemple de réalisation d'une structure d'absorption thermique S3 intégrant des moyens pour extraire la chaleur absorbée par le MCP. La structure est similaire à celle de la figure 1, et comporte en plus des canaux 9 de circulation d'un caloporteur.

Dans l'exemple représenté, les canaux 9 s'étendent entre des cellules sensiblement parallèlement à l'axe X. Cependant cette réalisation n'est en aucun cas limitative. En variante, les canaux 9 pourraient être orientés orthogonalement aux axes X et Y.

Dans l'exemple représenté, les canaux 9 sont formés par un jeu entre des cellules. En variante on pourrait former ces canaux 9 en supprimant des cellules.

La circulation du caloporteur dans les canaux 9 peut se faire soit de manière continue, soit en fonction des besoins de déstockage suite à la détection d'un pic de chaleur. Par exemple, l'eau ou l'huile est utilisée comme caloporteur.

Le caloporteur après avoir circulé dans les canaux 9 échange sa chaleur avec l'environnement extérieur par exemple.

Sur la figure 4, on peut voir un quart de vue en coupe d'un exemple de réalisation pratique d'une structure d'échangé thermique S3' similaire à la structure S3.

Par exemple, la structure S3' de la figure 4 est réalisée par fusion laser.

Cette structure comporte un boîtier 12 dans lequel des cellules de trois tailles différentes 102, 202, 302 interconnectées sont réalisées. Les cellules ont la forme de parallélépipèdes rectangles, leurs longueurs étant sensiblement parallèles. Comme on peut le voir, les cellules 102, 202, 302 sont réparties pas couche en fonction de leur taille. En considérant que la surface d'extrémité 1 se situe en bas dans la représentation de la figure 4, les cellules de plus petite taille 302 sont du côté de la surface d'extrémité 1, puis les cellules de taille intermédiaire 202 sont situées sur les cellules de plus petite taille et enfin les cellules de grande taille 102 sont situées sur les cellules de taille intermédiaire 202.

Comme représenté, la structure est orientée de sorte que le flux thermiques FT s'applique préférentiellement du côté des cellules de petite taille 302.

Les canaux de circulation d'un caloporteur s'étendent entre des blocs de cellules B1, B2, B3 et sont alimentés en parallèle par un connecteur arrière 10. En outre, les parois des canaux 9 forment des chemins de conduction thermique privilégiés 8 au sein de la structure S3', qui sont prolongées par les parois des cellules 102, 202, 302.

Latéralement, la structure S3' est isolée thermiquement par des évidements 7' s'étendant sur toute la hauteur de la structure.

Le remplissage des cellules avec le MCP se fait par exemple par les cellules de grande taille 102, le MCP se déversant dans les cellules de taille intermédiaire 202 et de petite taille 302. Un couvercle (non représenté) est ensuite fixé sur le boîtier pour fermer de manière étanche les cellules.

Par exemple, les plus petites cellules 302 présentent une section de coté de longueur 0,4 mm, les cellules de taille intermédiaire 202 présentent une section de coté de longueur 1,5 mm et les cellules de grande taille 302 présentent une section de coté de longueur 5 mm. Le volume de MCP est de 0,08 mm3 à 0,096 mm$^3$ pour les plus petites cellules 302 ; de 4,24 mm$^3$ à 5 mm$^3$ pour les cellules de taille intermédiaire 202 et de 157 mm$^3$ à 186 mm$^3$ pour les cellules de grande taille 302.

Dans le cas où les cellules sont des cylindres, les canaux pourrait être délimités directement par les espaces laissés libres entre les cellules.

A titre d'exemple numérique uniquement, nous allons maintenant calculer les dimensions des cellules et des chemins de conduction privilégiés pour plusieurs MCP et matériaux conducteurs thermiques.

Le transfert de la chaleur de l'extérieur de la structure vers le MCP s'effectue suivant deux trajets : un premier trajet à l'échelle d'une cellule, entre l'enveloppe de la cellule et le MCP, et un deuxième trajet à l'échelle de la structure dans les chemins de conduction privilégiés.

A l'échelle de la cellule, la cinétique du transport de chaleur dépend alors des conditions de température sur l'enveloppe de la cellule et des propriétés physiques du MCP :

La position du front de changement de phase désigné s(t) peut être modélisée par l'équation suivante :

$$s(t) = \sqrt{2.\frac{\lambda \Delta T}{L}.t} \qquad \text{(i)}$$

où

- s(t) est la position du front de changement de phase (ou profondeur de pénétration thermique) à l'instant t,
- $\lambda$ est la conductivité thermique du MCP (W/k.m),
- $\Delta T$ est la différence de température entre l'enveloppe et le matériau MCP en cours de transformation,
- L la chaleur latente de changement de phase du MCP (J/m$^3$).

Il est ainsi possible de définir, pour un matériau MCP donné, un domaine de temps (ou de fréquence) et d'espace (volume de la cellule) dans lequel le changement de phase est complet et, par voie de conséquence, le stockage thermique est optimal.

Le calcul a été réalisé pour quatre MCP différents de type sels et composés de sels, dont les propriétés physiques sont regroupées dans le tableau T1 ci-dessous.

| PCM | T (°C) | KJ/cm3 | Conductivité thermique (W/K/m) |
|---|---|---|---|
| LiNO3 | 250 | 0,6 | 1,38 |
| NaNO3 | 305 | 0,3 | 0,8 |
| KNO3 | 340 | 0,2 | 0,9 |
| NaNO3-KNO3 | 222 | 0,2 | 0,8 |

Tableau T1

La deuxième colonne donne la température de changement de phase solide/liquide

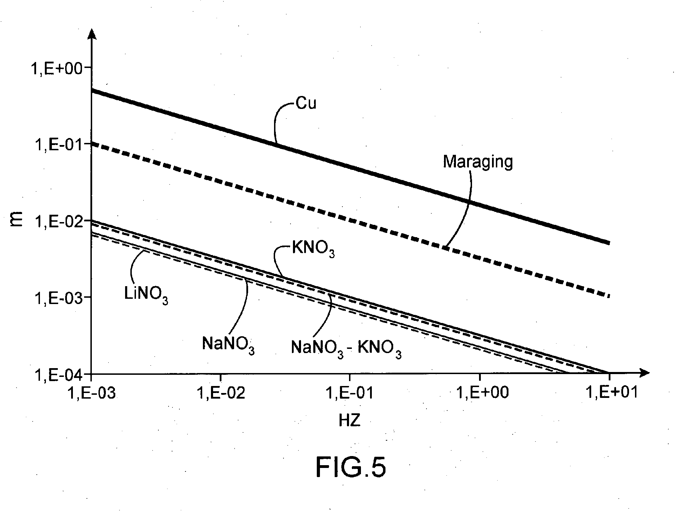

Sur la figure 5, on peut voir la variation de la profondeur de pénétration thermique en mètre pour les MCP ci-dessus en fonction de la fréquence du flux thermique en Hz. Pour les calculs, ΔT a été choisi égal à 10°C.

Dans le tableau T2 ci-dessous sont regroupées des valeurs de la position du front de changement de phase pour les différents MCP.

**Tableau T2**

|  | $LiNO_3$ | $NaNO_3$ | $KNO_3$ | $NaNO_3$- $KNO_3$ |
|---|---|---|---|---|
| s(0,01 Hz) en mm | 2,1 | 2,2 | 3,2 | 2,8 |
| S(0,1 Hz) en mm | 0,7 | 0,7 | 1,0 | 0,9 |

Pour une sollicitation thermique de 100 secondes (0,01 Hz), le stockage dans un MCP de type $NaNO_3$-$KNO_3$ sera optimal si la dimension de cellule est de l'ordre de 2,8 mm.

La dimension dont il est question ici est la dimension selon l'axe X, puisque la chaleur se distribue le long de l'axe X comme schématisé sur les figures 1 et 2. Dans le cas d'une cellule à section carrée comme sur la figure 4, il s'agit de la dimension du côté du carré.

Pour une sollicitation thermique de 10 secondes (0,1 Hz), le stockage dans un MCP de type $NaNO_3$-$KNO_3$ sera optimal si la dimension de cellule est de l'ordre de 0,9 mm.

Par conséquent, grâce à l'invention, on peut dimensionner la taille des différentes cellules en fonction des conditions transitoires multiples d'opération de la source de chaleur, les conditions transitoires pouvant être simultanées ou décalées dans le temps.

Nous allons maintenant calculer la longueur optimale des chemins de conduction privilégiés. A l'échelle de la structure, le chemin thermique de transport de la chaleur est celui de la conduction de la chaleur dans le matériau des chemins de conduction privilégiés qui est de préférence celui des enveloppes des cellules. La cinétique du transport dépend alors du flux de chaleur incident, de l'architecture et des propriétés physiques du matériau conducteur. Statistiquement, une profondeur moyenne de pénétration thermique peut être définie comme suit :

$$\delta(\omega) = \sqrt{\frac{2D}{\omega}} \qquad\qquad (ii)$$

avec

D : la diffusivité thermique du matériau en $m^2$/s
ω : la fréquence du signal thermique.

Nous prenons les exemples du cuivre et de l'acier Maraging pour réaliser les chemins de conduction privilégiés, dont les propriétés physiques sont regroupées dans le tableau T3 ci-dessous.

**Tableau T3**

| Conducteur | Difficulté ($m^2$/s) |
|---|---|
| Maraging | $4,90.10^{-6}$ |
| Cuivre | $1,20.10^{-6}$ |

Sur la figure 5, on peut voir la pénétration thermique dans le matériau d'enveloppe en fonction de la fréquence.

Dans le tableau T4 ci-dessous sont regroupées des valeurs de la position du front de pénétration thermique pour l'acier Maraging et le cuivre.

**Tableau T4**

|  | Maraging | Cuivre |
|---|---|---|
| δ(0,01 Hz) en mm | 31,3 | 153,5 |
| δ(0,1 Hz) en mm | 9,9 | 48,5 |

Pour une sollicitation thermique de 100 secondes (0,01 Hz), les profondeurs de pénétration de la chaleur dans l'acier Maraging et dans le cuivre sont, respectivement, de l'ordre de 9,9 et 48,5 mm,

Pour une sollicitation thermique de 10 secondes (0,1 Hz), les profondeurs de pénétration de la chaleur dans l'acier Maraging et le cuivre sont, respectivement, de l'ordre de 31,3 mm et 153,5 mm.

Par conséquent, afin d'obtenir un rendement de stockage maximal, la longueur des chemins de conduction privilégiés de chaleur, et donc sensiblement la hauteur du dispositif de stockage, sont choisies inférieures à ces valeurs.

De préférence, la largeur des chemins de conduction thermique privilégiés est comprise entre l'épaisseur de l'enveloppe et la largeur d'une cellule.

Nous allons décrire la méthode de détermination des différentes tailles de cellules et leur pourcentage dans une structure d'absorption thermique en fonction du signal d'un flux thermique donnée.

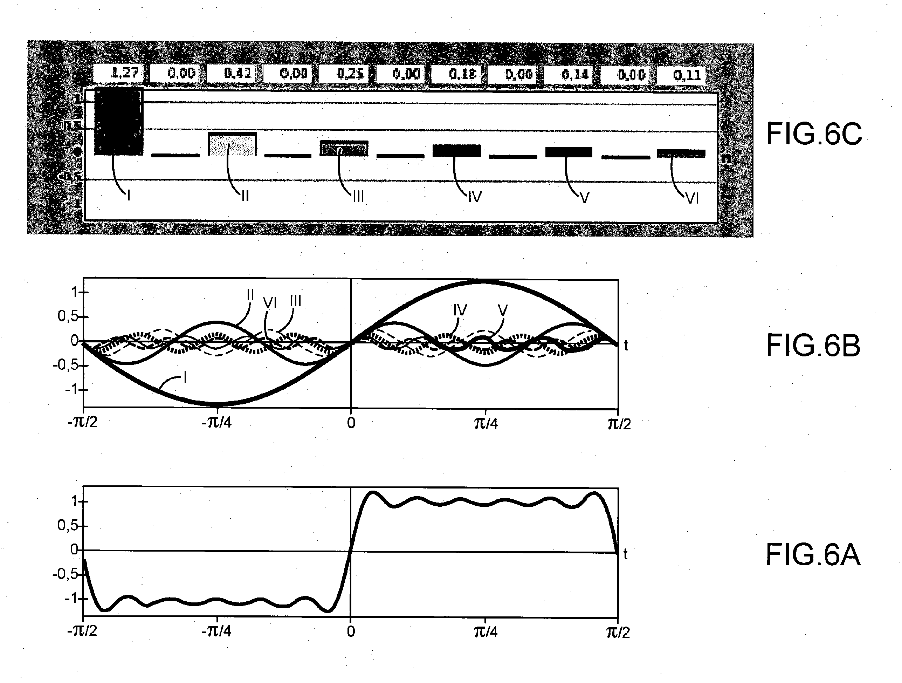

Nous considérons une source de chaleur en fonction carrée de période T comme représenté sur la figure 6A.

Lors d'une première étape, on représente celle-ci par un développement limité d'ordre n de fonctions sinusoïdales, correspondant chacune à une source de chaleur individuelle de fréquence n/T. La figure 6B propose un développement limité d'ordre 11 de cette fonction. On peut voir les fonctions sinusoïdales dont l'amplitude est la plus importante désignées par I à VI, chacune représentative d'un événement thermique périodique de la source de chaleur.

Sur la figure 6C, on peut voir l'amplitude thermique de chacun des ces signaux.

Lors d'une étape suivante, on sélectionne les signaux ayant les amplitudes les plus élevées. Par exemple, on sélectionne les signaux ayant les fréquences f1, f3 et f5, les autres signaux ayant des amplitudes très faibles.

Avantageusement on sélectionne les signaux dont la somme des amplitudes représente entre 60% e 98% de l'amplitude maximale du flux thermique.

Connaissant les fréquences f1, f3 et f5, il est possible de déterminer la taille des cellules comme expliquer précédemment à partir de l'équation (i) et en fonction du rapport entre l'amplitude des signaux et l'amplitude totale, on détermine la fraction de cellules de chaque taille.

On obtient alors une structure ayant trois tailles de cellules différentes. Dans le tableau T5, sont regroupés les dimensions des cellules et leur répartition. La taille des cellules a été calculée en considérant comme MCP du NaNO3-KNO3.

**Tableau T5**

| Source | m₁ | | | | m₃ | | | | m₆ | | | |
|---|---|---|---|---|---|---|---|---|---|---|---|---|
| | Amplitude | Fréquence | Maille | % | Amplitude | Frequence | Maille | % | Amplitude | Fréquence | Maille | % |
| T/2= 100 secondes | 1,27 | 0,005 Hz | 4,0 mm | 65% | 0,42 | 0,015 Hz | 2,3 mm | 22% | 0,25 | 0,025 Hz | 1,8 mm | 13% |
| T/2= 10 secondes | 1,27 | 0,050 Hz | 1,3 mm | 65% | 0,42 | 0,150 Hz | 0,7 mm | 22% | 0,25 | 0,250 Hz | 0,6 mm | 13% |

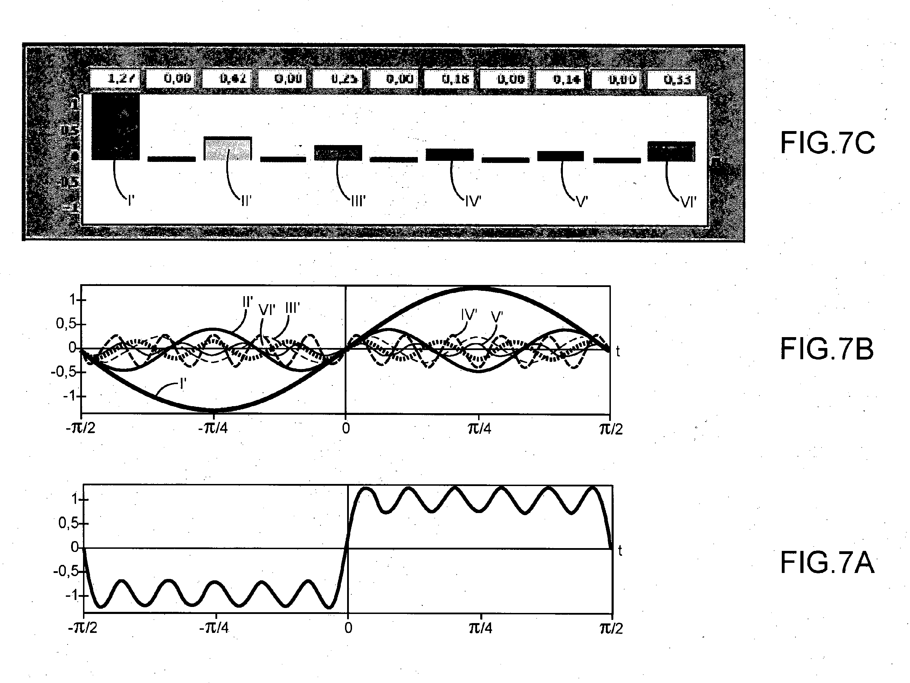

Sur les figures 7A à 7C, on peut voir un 5 autre exemple de développement d'une fonction carrée représentative d'une source de chaleur, les fonctions sinusoïdales dont l'amplitude est la plus importante sont désignées par I' à VI'. Dans ce cas, l'amplitude du signal du 11ème ordre, repéré par VI', est de 33. La structure peut alors être réalisée avec quatre tailles de cellules ou alors le signal du 5éme ordre, repéré par V', n'est plus pris en compte.

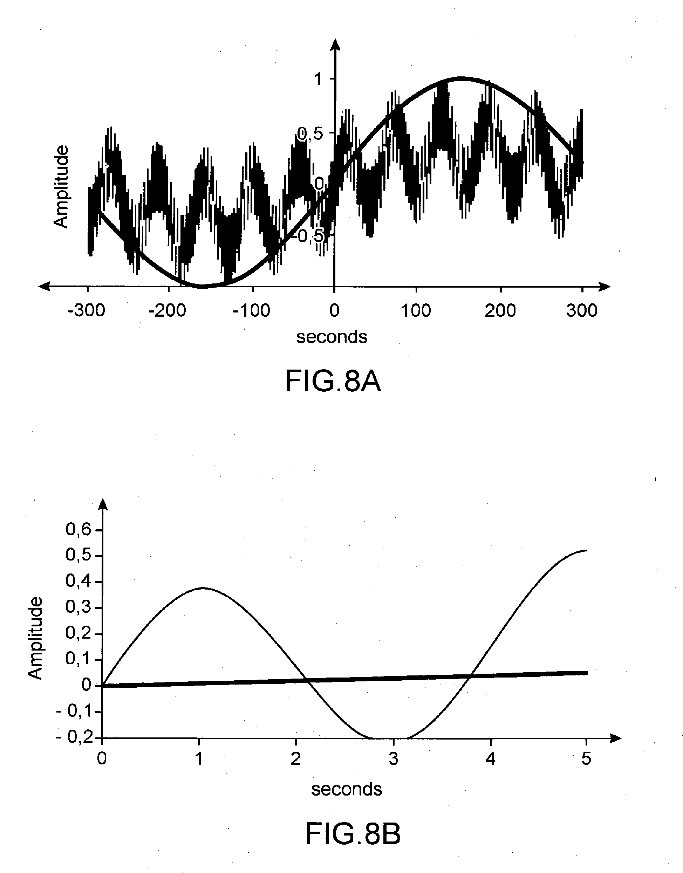

Sur les figures 8A et 8B, on peut voir les signaux des signaux représentatifs d'un flux thermique auquel la structure de la figure 4 est particulièrement adaptée, seules les échelles de temps varient entre les deux représentations graphiques.

Sur la figure 4, les trois tailles de cellules ont la même fraction volumique, i.e. 33%

Dans le tableau T6 ci-dessous sont regroupées les tailles de cellule en fonction des fréquences.

Tableau T6

| | m1 | | | | m2 | | | | m3 | | |
|---|---|---|---|---|---|---|---|---|---|---|---|
| Amplitude | Fréquence | Maille | % | Amplitude | Fréquence | Maille | % | Amplitude | Fréquence | Maille | % |
| 1 | 0,003 Hz | 5,0 mm | 33 % | 1 | 0,035 Hz | 1,5 mm | 33% | 1 | 0,500 Hz | 0,4 mm | 33% |

Après avoir déterminé le nombre et la taille des cellules, il est possible de fabriquer un dispositif d'absorption thermique selon l'invention.

Il est envisageable d'avoir des MCP différents dans la structure, par exemple en fonction de la taille et/ou de la position des cellules par rapport à la source de chaleur.

L'invention offre donc un dispositif d'absorption thermique particulièrement adapté à des systèmes ayant des conditions multiples de fonctionnement, en particulier à des systèmes du domaine de l'électronique, de la microélectronique et de l'électronique de puissance dont les flux thermiques émis dépendent du fonctionnement des composants. En outre, le dispositif d'absorption selon l'invention peut être réalisé spécifiquement en fonction du profil du flux thermique de chaque système.

**Revendications**

1. Dispositif d'absorption thermique comportant une structure (S1, S2, S3, S3') comprenant une pluralité de cellules individuelles (2, 102, 202, 302), chaque cellule (2, 102, 202, 302) étant délimitée par une enveloppe en un matériau présentant une bonne conductivité thermique et contenant au moins un matériau à changement de phase (MCP), ladite structure comportant une première surface d'extrémité (1) destinée à être en contact avec une surface émettant un flux thermique (FT) à absorber, ledit flux thermique (FT) étant composé d'au moins deux événements thermiques d'amplitudes différentes et de fréquences différentes, ladite structure (S1, S2, S3, S3') comprenant au moins une première taille de cellule et une deuxième taille de cellule ledit dispositif étant caracterisé en ce que lesdites cellules (2, 102, 202, 302) sont empilées les unes sur les autres à partir de ladite surface d'extrémité de sorte que la structure (S1, S2, S3, S3') s'étende au moins le long de la direction du flux thermique (FT), les cellules (2, 102, 202, 302) étant en contact les unes avec les autres par leur enveloppe, et en ce que la quantité de matériau à changement de phase dans chaque cellule (102, 202, 302) est proportionnelle à sa taille, dans lequel la première taille de cellule est déterminée en fonction de la fréquence du première événement et la deuxième taille de cellule est déterminée en fonction de la fréquence du deuxième événement et dans lequel la répartition entre le nombre de cellules de première taille et le nombre de cellules de deuxième taille est déterminée en fonction des amplitudes des premier et deuxième événements, et dans lequel la première taille de cellule et la deuxième taille de cellule augmentent lorsque que la fréquence du premier événement et la fréquence du deuxième événement respectivement diminuent et dans lequel le nombre de cellules de première taille et le nombre de cellules de deuxième taille augmentent lorsque l'amplitude du premier événement et l'amplitude du deuxième événement respectivement augmentent.

2. Dispositif d'absorption thermique selon la revendication 1, dans lequel la fréquence du deuxième événement est inférieure à celle du premier événement, la deuxième taille de cellule étant supérieure à la première taille de cellule, et dans lequel les cellules de première (202, 302) taille sont situées du côté de la première surface d'extrémité (1).

3. Dispositif d'absorption thermique selon la revendication 1 ou 2, dans lequel la taille des cellules (302, 202, 102) croît le long de la direction du flux thermique à partir de la première surface d'extrémité.

4. Dispositif d'absorption thermique selon l'une des revendications 1 à 3, dans lequel les cellules (2, 102, 202, 302) sont interconnectées de sorte à permettre le passage des matériaux à changement de phase d'une cellule à l'autre, les cellules étant avantageusement interconnectées dans la direction du flux thermique (FT).

5. Dispositif d'absorption thermique selon l'une des revendications 1 à 4, comportant au moins un chemin de conduction thermique privilégié (8) s'étendant à partir de la première surface d'extrémité (1) dans la direction du flux thermique entre les cellules (102, 202, 302), avantageusement plusieurs chemins de conduction privilégiés (8) étant répartis régulièrement dans la structure (S2, S3').

6. Dispositif d'absorption thermique selon la revendication 5, dans lequel la taille du au moins un chemin de conduction privilégié (8) représente de 20% à 100% de la taille de la cellule

7. Dispositif d'absorption thermique selon la revendication 5, dans lequel le au moins un chemin de conduction privilégié (8) est formé par une portion de matériau conducteur thermique située entre les cellules (102, 202, 302) et s'étendant le long de la direction du flux thermique, la portion de matériau conducteur thermique étant avantageusement du même matériau que celui de parois des cellules, par exemple en cuivre ou en acier Maraging.

8. Dispositif d'absorption thermique selon la revendication 7, dans lequel la portion de matériau conducteur thermique et les enveloppes des cellules en contact avec ladite portion sont d'un seul tenant.

9. Dispositif d'absorption thermique selon l'une des revendications 1 à 8, comportant des moyens (9) pour extraire la chaleur latente stockée dans le matériau à changement de phase.

10. Dispositif d'absorption thermique selon la revendication 9, dans lequel les moyens (9) pour extraire la chaleur latente comportent au moins un canal entre les cellules, dans lequel circule un caloporteur.

11. Dispositif d'absorption thermique selon la revendication 10, dans lequel la circulation du caloporteur est commandée en fonction de la survenue d'un événement thermique.

12. Dispositif d'absorption thermique selon l'une des revendications 1 à 11, comportant des moyens (5) pour isoler thermiquement les bords latéraux de l'empilement.

13. Dispositif d'absorption thermique selon l'une des revendications 1 à 12, le au moins un matériau à changement de phase mis en oeuvre ayant une température de changement de phase comprise entre 50°C et 350°C.

14. Dispositif d'absorption thermique selon l'une des revendications 1 à 13, comportant trois tailles de cellules de forme parallélépipédique (102, 202, 302), les cellules de chaque taille étant disposées dans une couche, les cellules étant interconnectées entre chaque couche.

15. Procédé de réalisation d'un dispositif d'absorption thermique selon l'une des revendications 1 à 14 destiné à absorber un flux thermique (FT) de période (T) émis par une source de chaleur, comportant les étapes :

   a) calcul à partie de la fonction représentative dudit flux thermique de période (T) d'un développement limité d'ordre n de fonctions périodiques, par exemple sinusoïdales, correspondant chacune à une source de chaleur individuelle de fréquence (n/T),
   b) sélection des fonctions périodiques, par exemples sinusoïdales, dont la somme des amplitudes est supérieure à un pourcentage donné de l'amplitude maximale du flux thermique,
   c) détermination de la taille des cellules en fonction des fréquences des fonctions sélectionnées, la taille des cellules augmentant lorsque que la fréquence des fonctions sélectionnées diminue,
   d) détermination de la répartition du nombre de cellules de chaque taille en fonction de l'amplitude des fonctions sélectionnées, le nombre de cellules de chaque taille augmentant lorsque l'amplitude des fonctions sélectionnées, augmente".
   e) réalisation d'un dispositif muni de cellules dont la taille et le nombre correspondent à ceux déterminés lors des étapes c) et d).

16. Procédé de réalisation selon la revendication 15, le pourcentage donné étant compris entre de 60 à 98%.


**Patentansprüche**

1. Wärmeabsorptionsvorrichtung, umfassend eine Struktur (S1, S2, S3, S3'), die eine Mehrzahl von einzelnen Zellen (2, 102, 202, 302) umfasst, wobei jede Zelle (2, 102, 202, 302) durch eine Umhüllung aus einem Material begrenzt ist, das eine gute thermische Leitfähigkeit aufweist, und wenigstens ein Phasenänderungsmaterial (MCP) enthält, wobei die Struktur eine erste Endoberfläche (1) umfasst, die dazu ausgelegt ist, in Kontakt mit einer Oberfläche zu sein, die einen zu absorbierenden thermischen Fluss (FT) emittiert, wobei der thermische Fluss (FT) aus wenigstens zwei thermischen Ereignissen mit unterschiedlichen Amplituden und unterschiedlichen Frequenzen zusammengesetzt ist, wobei die Struktur (S1, S2, S3, S3') wenigstens eine erste Zellengröße und eine zweite Zellengröße umfasst, wobei die Vorrichtung **dadurch gekennzeichnet** ist, dass die Zellen (2, 102, 202, 302) ausgehend von der Endoberfläche derart aufeinander gestapelt sind, dass sich die Struktur (S1, S2, S3, S3') wenigstens entlang der Richtung des thermischen Flusses (FT) erstreckt, wobei die Zellen (2, 102, 202, 302) durch ihre Umhüllung miteinander in Kontakt sind, und dass die Menge des Phasenänderungsmaterials in jeder Zelle (102, 202, 302) proportional zu ihrer Größe ist, wobei die erste Zellengröße als Funktion der Frequenz des ersten Ereignisses bestimmt ist und die zweite Zellengröße als Funktion der Frequenz des zweiten Ereignisses bestimmt ist, und wobei die Verteilung zwischen der Zahl von Zellen der ersten Größe und der Zahl von Zellen der zweiten Größe als Funktion der Amplituden des ersten und des zweiten Ereignisses bestimmt ist, und wobei die erste Zellengröße und die zweite Zellengröße zunehmen, wenn sich die Frequenz des ersten Ereignisses und die Frequenz des zweiten Ereignisses jeweils verringern, und wobei die Zahl von Zellen der ersten Größe und die Zahl von Zellen der zweiten Größe zunehmen, wenn die Amplitude des ersten Ereignisses und die Amplitude des zweiten Ereignisses jeweils zunehmen.

2. Wärmeabsorptionsvorrichtung nach Anspruch 1, bei der die Frequenz des zweiten Ereignisses kleiner ist als jene des ersten Ereignisses, die zweite Zellengröße größer ist als die erste Zellengröße, und bei der die Zellen der ersten (202, 302) Größe auf der Seite der ersten Endoberfläche (1) angeordnet sind.

3. Wärmeabsorptionsvorrichtung nach Anspruch 1 oder 2, bei der die Größe der Zellen (302, 202, 102) ausgehend von der ersten Endoberfläche entlang der Richtung des thermischen Flusses zunimmt.

4. Wärmeabsorptionsvorrichtung nach einem der Ansprüche 1 bis 3, bei der die Zellen (2, 102, 202, 302) derart miteinander verbunden sind, dass der Durchgang der Phasenänderungsmaterialien von einer Zelle zur anderen ermöglicht wird, wobei die Zellen vorzugsweise in der Richtung des thermischen Flusses (FT) miteinander verbunden sind.

5. Wärmeabsorptionsvorrichtung nach einem der Ansprüche 1 bis 4, umfassend wenigstens einen privilegierten Wärmeleitungsweg (8), der sich ausgehend von der ersten Endoberfläche (1) in Richtung des thermischen Flusses zwischen den Zellen (102, 202, 302) erstreckt, vorzugsweise mehrere privilegierte Leitungswege (8), die regelmäßig in der Struktur (S2, S3') verteilt sind.

6. Wärmeabsorptionsvorrichtung nach Anspruch 5, bei der die Größe des wenigstens einen privilegierten Wärmeleitungswegs (8) zwischen 20% und 100% der Größe der Zelle darstellt.

7. Wärmeabsorptionsvorrichtung nach Anspruch 5, bei der der wenigstens eine privilegierte Wärmeleitungsweg (8) durch einen Teil des Wärmeleitermaterials gebildet ist, das zwischen den Zellen (102, 202, 302) angeordnet ist und sich entlang der Richtung des thermischen Flusses erstreckt, wobei der Teil des Wärmeleitermaterials vorzugsweise aus dem gleichen Material ist wie jenes der Zellenwände, beispielsweise aus Kupfer oder aus Maraging-Stahl.

8. Wärmeabsorptionsvorrichtung nach Anspruch 7, bei der der Teil von Wärmeleitermaterial und die Umhüllungen der Zellen in Kontakt mit dem Teil einstückig sind.

9. Wärmeabsorptionsvorrichtung nach einem der Ansprüche 1 bis 8, umfassend Mittel (9) zum Extrahieren der latenten Wärme, die in dem Wärmeänderungsmaterial gespeichert ist.

10. Wärmeabsorptionsvorrichtung nach Anspruch 9, bei der die Mittel (9) zum Extrahieren der latenten Wärme wenigstens einen Kanal zwischen den Zellen umfassen, in dem ein Wärmeträger zirkuliert.

11. Wärmeabsorptionsvorrichtung nach Anspruch 10, bei der die Zirkulation des Wärmeträgers als Funktion des Auftretens eines thermischen Ereignisses gesteuert ist.

12. Wärmeabsorptionsvorrichtung nach einem der Ansprüche 1 bis 11, umfassend Mittel (5) zum thermischen Isolieren der lateralen Ränder des Stapels.

13. Wärmeabsorptionsvorrichtung nach einem der Ansprüche 1 bis 12, wobei das wenigstens eine eingesetzte Phasenänderungsmaterial eine Phasenänderungstemperatur hat, die zwischen 50°C und 350°C enthalten ist.

14. Wärmeabsorptionsvorrichtung nach einem der Ansprüche 1 bis 13, umfassend drei Größen von Zellen mit Parallelepipedform (102, 202, 302), wobei die Zellen jeder Größe in einer Schicht angeordnet sind, wobei die Zellen zwischen jeder Schicht verbunden sind.

15. Verfahren zur Herstellung einer Wärmeabsorptionsvorrichtung nach einem der Ansprüche 1 bis 14, die dazu ausgelegt ist, einen thermischen Fluss (FT) mit Periode (T) zu absorbieren, der von einer Wärmequelle emittiert wird, umfassend die Schritte:

a) Berechnung, ausgehend von der darstellenden Funktion des thermischen Flusses mit Periode (T), einer begrenzten Entwicklung der Ordnung n von periodischen Funktionen, beispielsweise sinusförmigen, von denen jede einer einzelnen Wärmequelle mit Frequenz (n/T) entspricht,
b) Auswahl von periodischen Funktionen, beispielsweise sinusförmigen, deren Amplitudensumme größer ist als ein gegebener Prozentsatz der maximalen Amplitude des thermischen Flusses,

c) Bestimmung der Größe der Zellen als Funktion der Frequenzen der ausgewählten Funktionen, wobei die Größe der Zellen zunimmt, wenn die Frequenz der ausgewählten Funktionen kleiner wird,

d) Bestimmung der Verteilung der Zahl von Zellen jeder Größe als Funktion der Amplitude der ausgewählten Funktionen, wobei die Zahl von Zellen jeder Größe zunimmt, wenn die Amplitude der ausgewählten Funktionen zunimmt,

e) Herstellung einer Vorrichtung, die mit Zellen ausgestattet ist, deren Größe und Zahl jenen entsprechen, die während der Schritte c) und d) bestimmt wurden.

**16.** Verfahren zur Herstellung nach Anspruch 15, wobei der gegebene Prozentsatz zwischen 60 und 98 % enthalten ist.

**Claims**

**1.** Heat absorbing device comprising a structure (S1, S2, S3, S3') having a plurality of individual cells (2, 102, 202, 302), each cell (2, 102, 202, 302) being delimited by an envelope made of a material that has good thermal conductivity and contains at least one phase-change material (PCM), said structure comprising a first end surface (1) intended to be in contact with a surface emitting a thermal flux (FT) to be absorbed, said thermal flux (FT) being made up of at least two thermal events of different amplitudes and different frequencies, said structure (S1, S2, S3, S3') comprising at least one first size of cell and one second size of cell, said device being **characterized in that** said cells (2, 102, 202, 302) are stacked on top of one another from said end surface so that the structure (S1, S2, S3, S3') extends at least in the direction of the thermal flux (FT), the cells (2, 102, 202, 302) being in contact with each other by their envelope, and **in that** the quantity of phase-change material in each cell (102, 202, 302) is proportional to its size, wherein the first size of cell is determined as a function of the frequency of the first event and the second size of cell is determined as a function of the frequency of the second event and wherein the distribution between the number of cells of first size and the number of cells of second size is determined as a function of the amplitudes of the first and second events, and wherein the first size of cell and the second size of cell increase when the frequency of the first event and the frequency of the second event respectively reduce and wherein the number of cells of first size and the number of cells of second size increase when the amplitude of the first event and the amplitude of the second event respectively increase.

**2.** Heat absorbing device according to claim 1, wherein the frequency of the second event is less than that of the first event, the second size of cell being greater than the first size of cell, and wherein the cells of first (202, 302) size are situated on the side of the first end surface (1).

**3.** Heat absorbing device according to claim 1 or 2, wherein the size of the cells (302, 202, 102) increases in the direction of the thermal flux from the first end surface.

**4.** Heat absorbing device according to one of claims 1 to 3, wherein the cells (2, 102, 202, 302) are interconnected so as to enable the passage of the materials with change of phase from one cell to the next, cells being advantageously interconnected in the direction of the thermal flux (FT).

**5.** Heat absorbing device according to one of claims 1 to 4, comprising at least one favoured heat conduction path (8) extending from the first end surface (1) in the direction of the thermal flux between the cells (102, 202, 302), several favoured conduction paths (8) being advantageously distributed regularly in the structure (S2, S3').

**6.** Heat absorbing device according to claim 5, wherein the size of the at least one favoured conduction path (8) represents from 20% to 100% of the size of the cell.

**7.** Heat absorbing device according to claim 5, wherein the at least one favoured conduction path (8) is formed by a portion of heat conducting material situated between the cells (102, 202, 302) and extending in the direction of the thermal flux, the portion of heat conducting material being advantageously of the same material as that of walls of the cells, for example made of copper or Maraging steel.

**8.** Heat absorbing device according to claim 7, wherein the portion of heat conducting material and the envelopes of the cells in contact with said portion are all in one piece.

**9.** Heat absorbing device according to one of claims 1 to 8, comprising means (9) for extracting the latent heat stored in the phase-change material.

10. Heat absorbing device according to claim 9, wherein the means (9) for extracting the latent heat comprise at least one channel between the cells, wherein circulates a coolant.

11. Heat absorbing device according to claim 10, wherein the circulation of the coolant is controlled as a function of the occurrence of a thermal event.

12. Heat absorbing device according to one of claims 1 to 11, comprising means (5) for thermally insulating the lateral edges of the stacking.

13. Heat absorbing device according to one of claims 1 to 12, the at least one phase-change material implemented having a phase change temperature comprised between 50°C and 350°C.

14. Heat absorbing device according to one of claims 1 to 13, comprising three sizes of cells of parallelepiped shape (102, 202, 302), the cells of each size being arranged in a layer, the cells being interconnected between each layer.

15. Method of forming a heat absorbing device according to one of claims 1 to 14 intended to absorb a thermal flux (FT) of period (T) emitted by a heat source, comprising the steps:

a) calculating from the function representative of the thermal flux of period (T) of a limited development of order n of periodic functions, for example sinusoidal, each corresponding to an individual heat source of frequency (n/T),
b) selecting periodic functions, for example sinusoidal, of which the sum of the amplitudes is greater than a given percentage of the maximum amplitude of the thermal flux,
c) determining the size of the cells as a function of the frequencies of the selected functions, the size of the cells increasing when the frequency of the selected functions decreases,
d) determining the distribution of the number of cells of each size as a function of the amplitude of the selected functions, the number of cells of each size increasing when the amplitude of the selected functions increases,
e) forming a device provided with cells of which the size and the number correspond to those determined during steps c) and d).

16. Method for forming according to claim 15, the given percentage being comprised between 60 to 98%.

FIG.1

FIG.2

FIG.3

FIG.4

FIG.5

FIG.6C

FIG.6B

FIG.6A

FIG.7C

FIG.7B

FIG.7A

EP 2 673 586 B1

FIG.8A

FIG.8B

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2007009687 A1